# EUROPEAN PATENT SPECIFICATION

(11) **EP 2 722 873 B1**
(45) Date of publication and mention of the grant of the patent: **04.08.2021**
(21) Application number: 13189440.4
(22) Date of filing: 18.10.2013
(51) Int. Cl.: H01L 21/306, H01L 21/3105, C09G 1/02, C09K 3/14

(54) **CHEMICAL MECHANICAL POLISHING (CMP) COMPOSITION FOR SHALLOW TRENCH ISOLATION (STI) APPLICATIONS AND METHODS OF MAKING THEREOF**
ZUSAMMENSETZUNG ZUM CHEMISCH-MECHANISCHEN POLIEREN (CMP) FÜR ANWENDUNGEN FÜR FLACHE GRABENISOLATION (STI) UND VERFAHREN ZUR HERSTELLUNG DAVON
COMPOSITION DE POLISSAGE CHIMICO-MÉCANIQUE (CMP) POUR DES APPLICATIONS D'ISOLATION DE TRANCHÉE PEU PROFONDE (STI) ET LEURS PROCÉDÉS DE FABRICATION

(30) Priority: 19.10.2012 US 201261716471 P; 18.09.2013 US 201314030657
(43) Date of publication of application: 23.04.2014
(73) Proprietor: Versum Materials US, LLC, Tempe, AZ 85284 (US)
(72) Inventor: Shi, Xiaobo, Chandler, AZ Arizona 85224 (US); Hughes, John Edward Quincy, Cave Creek, AZ Arizona 85331 (US); Zhou, Hongjun, Chandler, AZ Arizona 85248 (US); Castillo, II, Daniel Hernandez, Laveen, AZ Arizona 85339 (US); Choo, Jae Ouk, Chandler, AZ Arizona 85249 (US); Schlueter, James Allen, Phoenix, AZ Arizona 85045 (US); Schwartz, Jo-Ann Theresa, Fountain Hills, AZ Arizona 85268 (US); Nbach, Laura Lede, Gilbert, AZ Arizona 85298 (US); Winchester, Steven Charles, Phoenix, AZ Arizona 85040 (US); Usmani, Saifi, Phoenix, AZ Arizona 85048 (US); Marsella, John Anthony, Allentown, PA Pennsylvania 18104 (US); Mungai, Martin Kamau Ngigi, Gilbert, Arizona, 85298 (US)
(74) Representative: Beck Greener LLP

(56) References cited:
- WO-A1-2006/105020
- WO-A1-2008/023858
- WO-A2-2006/132905
- US-A- 5 021 567
- US-A- 5 230 833
- US-A- 6 117 220
- US-A1- 2009 130 849
- US-B2- 7 429 367
- US-B2- 7 993 420
- HYUN-GOO KANG: "effects of abrasive particles size and molecular weight of poly(acrylic acid) electrolyte in ceria slurry on removal selectivity of SiO2/Si3N4 films in shallow trench isolation chemical mechanical planarization", J. MATER. RES, vol. 22, no. 3, 3 March 2007 (2007-03-03), pages 777-787, XP002717298, DOI: 10.1557/JMR.2007.0097

## Description

### BACKGROUND OF THE INVENTION

This invention relates to the field of chemical mechanical planarization (CMP) for Shallow Trench Isolation (STI) processes. More specifically, the present invention is directed to methods or processes of reducing (treating) trace metal contaminants and smaller or fine sized cerium oxide particles in compositions comprising cerium oxide particles, such as cerium oxide slurries and STI polishing compositions.

Chemical mechanical polishing(CMP) compositions for Shallow Trench Isolation (STI) generally contain abrasive such as cerium oxide particles or colloidal cerium oxide particles, and suitable dispersing agents.

For example, US Patent 5,876,490 discloses polishing compositions containing abrasive particles and exhibiting normal stress effects. The slurry further contains non-polishing particles resulting in reduced polishing rate at recesses, while the abrasive particles maintain high polish rates at elevations. This leads to improved planarization. More specifically, the slurry comprises cerium oxide particles and polymeric electrolyte, and can be used for Shallow Trench Isolation (STI) polishing applications.

As another example, US Patent 6,964,923 teaches polishing compositions containing cerium oxide particles and polymeric electrolyte for Shallow Trench Isolation (STI) polishing applications. The polymeric electrolytes that are used include the salts of polyacrylic acid, similar to those in US Patent 5,876,490. Ceria, alumina, silica & zirconia are used as abrasives. The molecular weight of the polyelectrolytes is stated to be <100,000 and more typically from 300 to 20,000.

However, such Shallow Trench Isolation (STI) polishing compositions usually contain trace metal contaminants, that are known to cause defects in a STI CMP process. Such trace metal contaminants include, but are not limited to, Al, Zr, Fe, Ni and Mg.

In addition, the presence of very small or fine cerium or colloidal cerium oxide particles in the STI polishing compositions is also known to cause defects in a STI CMP process.

Thus, there is still a need for Shallow Trench Isolation (STI) polishing compositions that have reduced levels of trace metal contaminants and/or reduced levels of very small and fine cerium oxide particles, in order to achieve reduced occurrences of defects in STI chemical and mechanical polishing (CMP) processes.

US6117220 discloses a polishing composition for a memory hard disc, which comprises the following components (a) to (d): (a) water, (b) at least one compound selected from the group consisting of a polystyrenesulfonic acid, and its salts, (c) a compound selected from the group consisting of an inorganic acid and an organic acid, and their salts, other than component (b), and (d) at least one abrasive selected from the group consisting of aluminum oxide, silicon dioxide, cerium oxide, zirconium oxide, titanium oxide, silicon nitride and manganese dioxide.

US7993420 discloses a method wherein cerium oxide is processed through ion exchange in a mixed-bed resin, and the cerium oxide particles are filtered to produce a ceria material.

WO2008/023858 discloses manufacturing methods of fine cerium oxide particles and its slurry for shallow trench isolation process of semiconductor. To increase the removal selectivity, an aqueous solution of additives consisting of polyacrylic acid and amine compounds is added the cerium oxide slurry.

### BRIEF SUMMARY OF THE INVENTION

Described herein are CMP polishing methods for Shallow Trench Isolation (STI) processes. The CMP polishing compositions provide for reduced polishing defects due to the reduced levels of trace metal contaminants and reduced levels of smaller or fine sized cerium oxide particles. Described herein are also methods of reducing the levels of trace metal contaminants and smaller sized cerium oxide particles in cerium oxide slurries or Shallow Trench Isolation (STI) CMP polishing compositions. In a first aspect, there is provided a method of reducing trace metal contaminants and/or reducing cerium oxide particles having a particle size of less than 10 nm in a cerium oxide slurry, the method comprising one or more of the following steps (I) to (III):
(I) (a) adding an ion exchange resin to the cerium oxide slurry; and (b) removing the ion exchange resin from the cerium oxide slurry through filtration to obtain treated cerium oxide slurry; wherein the ion exchange resin is a cationic ion exchange resin selected from a cationic ion exchange resin having protons or potassium ions or an anionic ion exchange resin having a hydroxyl group;
(II)(a) adding a chemical additive to the cerium oxide slurry to form a mixture, wherein the chemical additive reacts with trace metal ions in the trace metal contaminants to form water soluble chemical additive-metal ion complexes in the mixture; (b) centrifuging the mixture; (c) collecting cerium oxide particles from the precipitate of the centrifugation; and (d) mixing deionized water with the collected cerium oxide particles to obtain a treated cerium oxide slurry; and
(III) adding a chemical chelator to the cerium oxide slurry to obtain treated cerium oxide slurry;
wherein
the chemical additive is selected from the group consisting of (a) organic acids selected from the group consisting of oxalic acid, citric acid, malic acid, tartaric acid, maleic acid, itaconic acid, gluconic acid, lactic acid, ETDA, and combinations thereof; (b) amino acids selected from the group consisting of glycine, alanine, serine, proline, and combinations thereof; (c) organic compounds containing at least one carboxylic acid group; (d) amino acid derivatives containing at least one amine acid moiety or iminodiacetic acid; (e) organic amine compounds selected from the group consisting of ethylene diamine, propylene diamine, ethylenimine, organic compound containing primary or secondary amino groups, and combinations thereof; (f) organic sulfuric acids containing at least one sulfuric acid group; (g) organic phosphoric acids containing at least one phosphoric acid group; (h) pyridine and its derivatives selected from the group consisting of pyridine, 2-methylpyridine, substituted pyridine at position 2, 3, 4, 5 or 6 respectively, and combinations thereof; (i) bipyridine and its derivatives selected from the group consisting of 2,2'- bipyrine, 4,4'-dimethyl bipyridine, 4,4'-bipyridine, and all other substituted 2,2'-bipyrine or 4,4'-bipyridine derivatives, and combinations thereof; U)terpyridine and its derivatives; (k) quinoline and its derivatives; (I) hydroxyl quinoline and its derivatives; (m) ammonium hydroxide; and combinations thereof; and the chemical chelator is hydroxyl quinoline or its derivative having a chemical structure selected from the group consisting of: 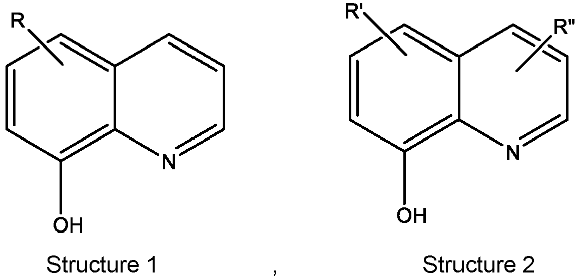 and combinations thereof;
wherein R is selected from the group consisting of hydrogen, alkyl, alkoxy, organic group with one or more hydroxyl groups, substituted organic sulfonic acid, substituted organic sulfonic acid salt, substituted organic carboxylic acid, substituted organic carboxylic acid salt, organic carboxylic ester, organic amine groups, and combinations thereof; and
R' and R" can be the same or different, and are independently selected from the group consisting of hydrogen, alkyl, alkoxy, organic group with one or more hydroxyl groups, substituted organic sulfonic acid, substituted organic sulfonic acid salt, substituted organic carboxylic acid, substituted organic carboxylic acid salt, organic carboxylic ester, organic amine, and combinations thereof; wherein the chemical chelator reacts with trace metal ions in trace metal contaminants to form metal ion-chelator complexes.

Preferably, the ion exchange resin is a cationicion exchange resin having potassium ions; the method in step (I) further comprising
(c) adding an anionic ion exchange resin having a hydroxyl group to the treated cerium oxide slurry after step (b); and
(d) removing the anionic ion exchange resin from the cerium oxide slurry in (c) through filtration; and
wherein the method preferably comprises repeating steps (a) to (d) at least twice.

Preferably, the method comprises the step of of running deionized water through the cerium oxide slurry using at least one ultra filtration membrane to obtain a treated cerium oxide slurry as retentate.

Preferably, the method further comprises sonication.

Preferably, the method comprises the steps of (a) centrifuging the cerium oxide slurry; (b) collecting cerium oxide particles from the precipitate of centrifugation; (c) mixing deionized water with the collected cerium oxide at least twice; so as to obtain a treated cerium oxide slurry comprising cerium oxide particles from the precipitate of the last centrifugation.

The metal ion-chelator complexes may then be easily removed to reduce defects caused by the trace metal contaminants.

In a second aspect, there is provided a method of forming a chemical mechanical polishing (CMP) composition for Shallow Trench Isolation (STI) comprising:
(a) reducing trace metal contaminants and/or reducing cerium oxide particles having a particle size of less than 10 nm in a cerium oxide slurry as described above to form a treated cerium oxide slurry;
(b) adding a polymeric electrolyte to the treated cerium oxide slurry; and
5 (c) adding a biocide to the treated cerium oxide slurry.

In a third aspect, there is provided a method of chemical mechanical polishing (CMP) a substrate having at least one surface comprising silicon dioxide in a Shallow Trench Isolation (STI) process, the method comprising polishing the substrate using a chemical mechanical polishing (CMP) composition selected from (a) a composition comprising a treated cerium oxide slurry obtained by the method of the first aspect of the invention; and (b) a composition obtained by the method of the second aspect of the invention.

Examples of a polymeric electrolyte include but are not limited to ammonium salt of polyacrylic acid, ammonium salt of polyvinyl sulfonic acid, ammonium salt of poly(4-styrene sulfonic acid), and combinations thereof. Examples of a chemical chelator include but are not limited to 8-hydroxyl quinoline, 8-hydroxyl quinoline-5-sulfonic acid, and combinations thereof.

Examples of a chemical additive include but are not limited to oxalic acid having concentration ranging from 0.01M to 0.1 M. The ion exchange resin can be a cationic ion exchange resin or an anionic ion exchange resin. Examples of a cationic ion exchange resin include but are not limited to proton or potassium ions; and an anionic ion exchange resin includes but is not limited to an anionic ion exchange resin having hydroxyl group.

### BRIEF DESCRIPTION OF SEVERAL VIEWS OF THE DRAWINGS

Figure 1 shows the impacts of STI Slurry with or without chelators on TEOS Removal Rates and Defect Counts.
Figure 2 shows the impacts of STI Slurry with or without chelators on Zr concentration reduction in chelator treated ceria particles.
Figure 3 shows the effects of different resin treatments on AI contents.

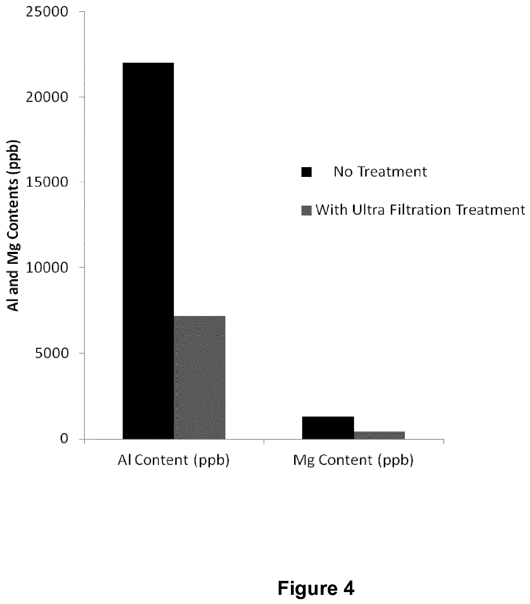

Figure 4 shows the effects of ultra filtration treatment on AI and Mg contents.

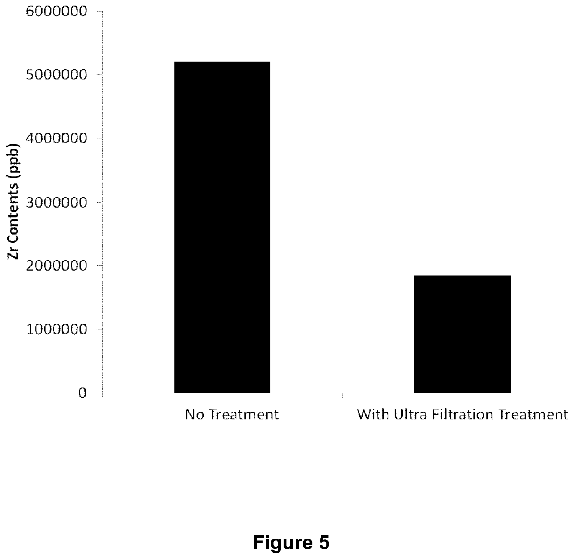

Figure 5 shows the effects of ultra filtration treatment on Zr contents.

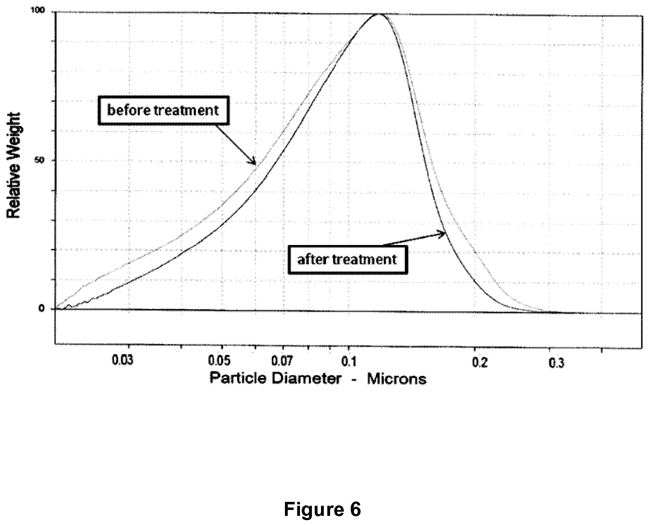

Figure 6 shows the particle size and distribution of the treated and re-dispersed cerium particles after the ultra filtration treatment.

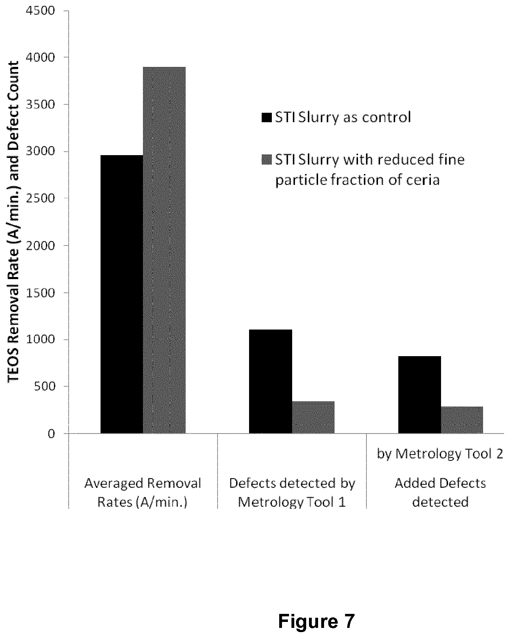

Figure 7 shows the impacts of STI Slurry with reduced fine ceria particles on TEOS Removal Rates and Defect Counts.
Figure 8 shows the effects of chemical additive treatment on AI contents - Figure 8 (a), on Mg contents -Figure 8 (b), and on Zr contents -Figure 8 (c).

### DETAILED DESCRIPTION OF THE INVENTION

Trace metal contaminants in polishing compositions include, but are not limited to, Al, Zr, Fe, Ni and Mg. In general, the presence of trace metal contaminants and smaller sized (<10nm) cerium oxide particles in polishing compositions are considered to be two root causes for potentially increased occurrences of nano-sized particle related polishing defects. Trace metal ions and their related oxide particles can migrate or penetrate into the oxide film lattices, forming nano-sized residues on wafer surfaces in a STI CMP process.

The present invention is directed to methods or processes of reducing the levels of trace metal contaminants and/or smaller or fine sized cerium oxide particles in compositions comprising cerium oxide particles, such as cerium oxide slurries or ceria abrasives. The present invention is also directed to methods or processes of reducing the levels of trace metal contaminants and/or smaller or fine sized cerium oxide particles in STI polishing compositions.

Removing or reducing trace metal contaminants and smaller sized cerium oxide particles in ceria abrasives or STI polishing compositions can reduce the levels or occurrences of defects that might otherwise be introduced during a STI CMP Process as a result of these trace metal contaminants or smaller sized cerium oxide particles being present in the polishing composition.

A number of treating methods or embodiments for reducing trace metals and smaller or fine sized cerium oxide particles are described herein.

### Chemical Chelator Treatment

A chemical additive acting as chelator may be added into the cerium oxide slurry or STI polishing composition. The chemical chelator reacts with trace metal ions to form neutral, or charged metal ion-chelator complexes. The complexes can be removed more easily from a wafer surface in a STI CMP process. Thus, trace metal contaminant induced defects can be reduced.

### Ion-Exchange Resin Treatment

An ion-exchange resin may be used to treat the cerium oxide slurry to remove trace metal ions from or reduce the amounts of trace metal ions in the cerium oxide slurry.

### Chemical Additive Treatment

By adding suitable chemical additives into the cerium oxide slurry, the solution may be treated either at room temperature or at elevated temperature with subsequent pH adjustment.

In such treatment, the suitable chemical additives can react with various trace metal ions to form water soluble chemical additive-metal ion complexes so that such water soluble chemical additive-metal ion complexes can be removed from the supernatant solution phase after centrifuging the treated cerium oxide slurry.

The cerium oxide slurry being treated by any one of the method described above can be further treated by any other, or any combination of other methods. For example, the cerium oxide slurry being treated by suitable chemical additives, can be further treated by any one of, or combinations of two of, Chemical Chelator Treatment andion exchange resin treatment, described above.

Upon the reduction of trace metal contaminants and/or smaller or fine sized cerium oxide particles in the cerium oxide slurry, the treated cerium oxide slurry is used to make STI polishing compositions. The levels or amounts of defects, such as caused by metal ions penetrating into silicon oxide films or forming nano-sized residues on wafer surfaces, that result from a STI CMP process can thus be reduced.

In the following working examples, a STI polishing composition comprising 1.5wt% cerium oxide with density larger than 6.8g/cm³; 0.1 to 0.5wt% an ammonium salt of polyacrylic acid; 0.000wt1% to 0.05wt% a biocide; and solvent being deionized water, was prepared. This STI polishing composition was used as a base/control reference.

A cerium oxide slurry comprising 40 wt% cerium oxide particles, and solvent being deionized water was also prepared and used as a base/control reference.

### Chemical Chelator Treatment

By adding a chemical additive as chelator (or ligand) to a STI polishing composition or a cerium oxide slurry, the chelator reacts with trace metal ions to form Metal lon-Chelator complexes.

The metal-ion-chelator complexes can be in neutral form with no net charges on the whole complex or the complexes can carry either a positive charge or a negative charge. The preferred form of the complexes is a non-charged neutral complex in aqueous solutions. The neutral complexes have less interactions with the silicon oxide films to be polished.

The complexes are removed more easily from wafer surface in a STI CMP process to potentially reduce or prevent the adhesion and the penetration of trace metal ions onto or into the high density silicon dioxide films. Thus, trace metal contaminant induced defects can be reduced to provide an enhanced polishing performance with reduced total defects.

Among above listed chelators or ligands, hydroxyl quinoline and its derivatives can form various complex compounds with different metal ions, such as aluminum, copper, nickel ions and others.

The hydroxyl quinoline and its derivatives have a molecular structure selected from one of the following two general molecular structures:

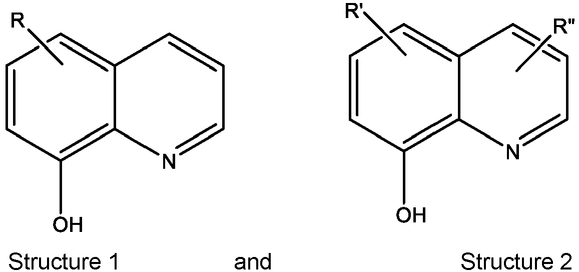

In molecular Structure 1, R is as defined above (the substituted organic sulfonic acid groups may, for example, have the formula -SO₂OH or -R"'SO₂OH, where R'" is an alkanediyl group or other bivalent saturated or unsaturated alkyl radical).

Hydroxyl quinoline, such as, 8-hydroxyl quinoline and 8-hydroxyl quinoline-5-sulfonic acid was used as the chelating reagents in the working examples.

### Working Examples

Compositions 1-4 are not covered by the invention, which relates to a method.

### Composition 1

100ppm 8-hydroxyl quinoline was added to the base STI polishing composition. The pH of the solution was about 5.5. The composition was then stirred overnight at room temperature.

The solution was then centrifuged at 10,000rpm for 60 minutes. The supernatant solutions and the remaining cerium oxide particles were collected separately. The supernatant solution was analyzed by ICP-Mass Spectroscopy (Full digestion). The supernatant solution of the base STI polishing composition was used as the reference.

### Composition 2

100ppm 8-hydroxyl quinoline-5-sulfonic acid was added to the base STI polishing composition. The pH of the solution was about 5.25. The composition was then stirred overnight at room temperature.

The solution was then centrifuged at 10,000rpm for 60 minutes. The supernatant solutions and the remaining cerium oxide particles were collected separately. The supernatant solution was analyzed by ICP-Mass Spectroscopy (Full digestion). The supernatant solution of the base STI polishing composition was used as the reference.

### Composition 3

1,000ppm 8-hydroxyl quinoline (chelator 1) was added to a 200mL of Cerium Oxide (ceria) Slurry (40 wt%). The pH of the solution was about 9.5. The solution was stirred overnight at room temperature.

The solution was then centrifuged at 10,000rpm for 60 minutes. The supernatant solutions and the remaining cerium oxide particles were collected separately. The supernatant solution was analyzed by ICP-Mass Spectroscopy (Full digestion). The supernatant solution from the base cerium oxide slurry was used as the reference.

### Composition 4

1,000ppm 8-hydroxyl quinoline-5-sulfonic acid hydrate (chelator 2) was added to a 200mL of Cerium Oxide (ceria) (40 wt%) slurry. The pH of the solution was about 9.5. The solution was stirred overnight at room temperature.

The solution was then centrifuged at 10,000rpm for 60 minutes. The supernatant solutions and the remaining cerium oxide particles were collected separately. The supernatant solution was analyzed by ICP-Mass Spectroscopy (Full digestion). The supernatant solution from the base cerium oxide slurry was used as the reference.

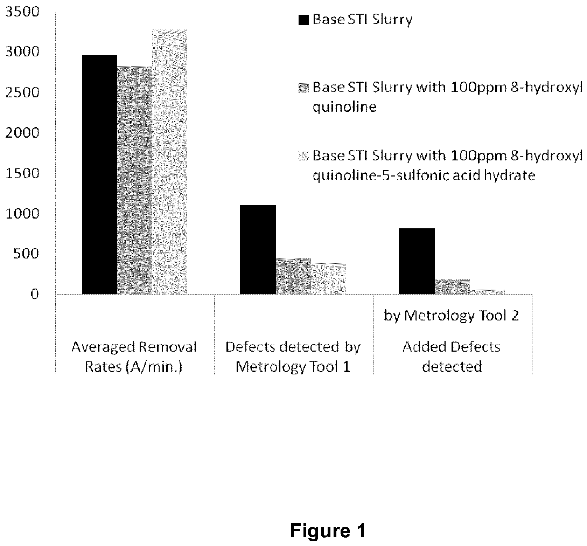

The results from compositions 1 and 2 are shown in Table 1 and Figure 1.

With the addition of 100ppm of 8-hydroxyl quinoline as the chelator additive, the averaged total defects after CMP process was reduced from 1107 for the base STI polishing composition to 443.

With the addition of 100ppm of 8-hydroxyl quinoline-5-sulfonic acid hydrate as the chelator additive, the averaged total defects after CMP process were reduced from 1107 for the base STI polishing composition to 385.

Polishing silicon dioxide (TEOS) films

**Table 1. Effects of Chelator in STI Slurry on Removal Rates and Defects**

| Composition | Averaged Removal Rates (A/min.) | Defects detected by Metrology Tool 1 | Added Defects detected by Metrology Tool 2 |
|---|---|---|---|
| Base STI Slurry | 2958 | 1107 | 821 |
| Base STI Slurry with 100ppm 8-hydroxyl quinoline | 2826 | 443 | 186 |
| Base STI Slurry with 100ppm 8-hydroxyl quinoline-5-sulfonic acid hydrate | 3290 | 385 | 58 |

It was observed that the total defects after CMP process detected by metrology tool 1 were reduced by using chelator 8-hydroxyl quinoline or 8-hydroxyl quinoline-5-sulfonic acid hydrate in the STI polishing composition, respectively.

Also as shown in Table 1, with the addition of 100ppm of 8-hydroxyl quinoline as the chelator additive, the averaged total added defects after CMP process was reduced from 1107 for the reference STI polishing composition to 443. With the addition of 100ppm of 8-hydroxyl quinoline-5-sulfonic acid hydrate as the chelator additive, the averaged total defects after CMP process was reduced from 1107 for the reference STI polishing composition to 385.

ICP-Mass Spectroscopy analytic results indicated a larger than 30% Zr concentration reductions on the composition being treated with two chelators.

The removal rates of polishing silicon dioxide film were also shown in Table 1. The result indicated that the removal rates were similar while having the benefit of reduced defects.

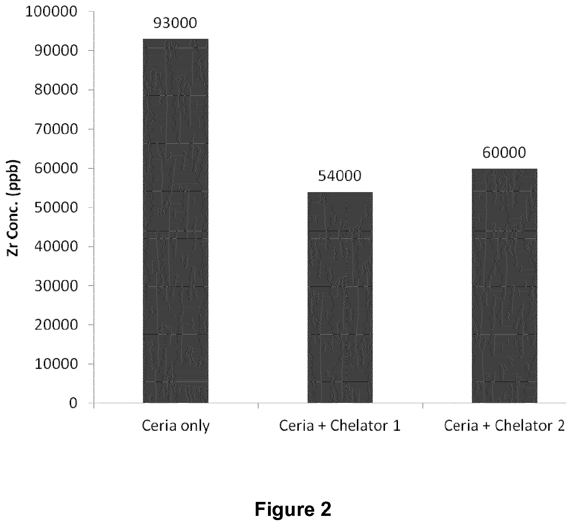

The results from compositions 3 and 4 are shown in Table 2 and Figure 2.

The addition of 1000ppm of 8-hydroxyl quinoline as the chelator additive (chelator 1), the averaged total added defects after CMP process was reduced from 93000 for the Cerium Oxide (40 wt%) slurry to 54000. With the addition of 1000ppm of 8-hydroxyl quinoline-5-sulfonic acid hydrate as the chelator additive(chelator 2), the averaged total defects after CMP process was reduced from 93000 for the Cerium Oxide (40 wt%) slurry to 60000.

**Table 2. Zr Concentration Reduction in Chelator Treated Ceria Particles**

| **Samples** | **Zr Conc. (ppb)** |
|---|---|
| **Ceria only** | **93000** |
| **Ceria + Chelator 1** | **54000** |
| **Ceria + Chelator 2** | **60000** |

ICP--Mass Spectroscopy analytic results indicated the Zr concentration of cerium oxide samples treated with chelator 1 or chelator 2 were reduced by more than 35% than that of reference cerium oxide sample without using any chelator for the treatment.

The cerium oxide slurry treated with chelator 1 or chelator 2 can then be used to prepare STI polishing compositions.

### Ion-Exchange Resin Treatment

### Working Example

Cerium oxide slurry was treated with various types of ion exchange resin. The ion exchange resin includes cationic ion exchange resin with potassium ions (Cationic-K Resin) or protons(Cationic-H Resin), and anionic ion exchange resin with hydroxyl groups (OH) (Anionic-OH Resin) on the surface.

In a typical ion exchange treatment process, either 40 wt% or diluted 10 wt% cerium oxide slurry was used. After treatment, the recovered cerium oxide slurry had concentrations several percent less than 40% and 10% respectively.

The ion exchange resin was added to or mixed with the cerium oxide slurry under stirring condition for 15 to 20 minutes. Afterwards, ion exchange resins were removed from the solution through filtration (filters). The steps were repeated at least three times to complete the ion exchange treatment.

Upon the completion of ion exchange resin treatment process, the collected cerium oxide slurry was centrifuged. The supernatant solutions and the residues of cerium oxide particles were collected for ICP-Mass Spectroscopy analysis on trace metal ion concentrations.

In the procedure described above, a cationic ion exchange resin with potassium ions was in some cases used to treat the cerium oxide slurry (Cationic-K resin). The final treated cerium oxide slurry was centrifuged.

In other cases, a cationic ion exchange resin with a proton functional group was used to treat the cerium oxide slurry(Cationic-H resin). The final treated cerium oxide slurry was centrifuged.

In yet other cases, a mixed treatment using both a cationic ion exchange resin and a anionic ion exchange resin was conducted, in accordance with the following procedure.

A cationic ion exchange resin having potassium ions was used to treat the cerium oxide slurry first. The treated cerium oxide slurry was separated from the cationic ion exchange resin, and was treated subsequently with the anionic ion exchange resin having hydroxyl group as the functional groups. Then, the treated cerium oxide slurry was separated from the anionic ion exchange resin.

This alternative mixed ion exchange resin treatment was repeated three times.

Then, the collected cerium oxide slurry was further centrifuged. The supernatant and cerium oxide particle residues were collected for ICP-Mass Spectroscopy analysis on trace metal ion concentrations respectively.

The original cerium oxide slurry, without ion exchange process treatment and the centrifuge process, was also analyzed as the reference for trace metal ion concentrations by ICP-Mass Spectroscopy analysis.

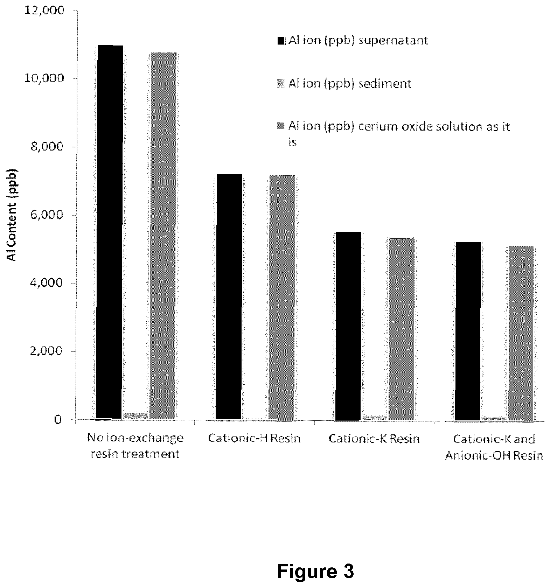

The results are shown in Table 3 and Figure 3.

**Table 3. Effects of Ion-Exchange Treatment on Aluminum Conc. In Cerium oxide slurry**

| Ion Exchange Resin | AI ion (ppb) supernatant | AI ion (ppb) sediment | AI ion (ppb) cerium oxide slurry as it is |
|---|---|---|---|
| No ion-exchange resin | 11,000 | 220 | 10,780 |
| Cationic-H Resin | 7,232 | 26 | 7,206 |
| Cationic-K Resin | 5,554 | 140 | 5,414 |
| Cationic-K Resin and Anionic-OH Resin | 5,281 | 120 | 5,161 |

As the results shown in Table 3 and Figure 3, the ion exchange treatment processes reduced trace metal ion concentrations, especially Aluminum ion concentrations.

All three different ion-exchange resin treatments have shown reduced trace aluminum ion concentrations to different degrees while comparing to the aluminum ion concentrations detected for the original cerium oxide slurry without using ion exchange resin treatments.

The cerium oxide slurry after ion-exchange resin treatments can be used to prepare STI polishing compositions.

### Chemical Additive Treatment

In this treatment, suitable chemical additives are added to the cerium oxide slurry. The suitable chemical additives can react with various trace metal ions in the cerium oxide slurry to form water soluble chemical additive-metal ion complexes so that such water soluble chemical additive-metal ion complexes can be removed from supernatant solution phase after centrifuging the treated cerium oxide slurry.

If the chemical additive is in solid state, then the first step of the method is adding the chemical additive into a cerium oxide slurry to treat the cerium oxide particles in the solution. If the chemical additive is a solution, then cerium oxide powder or cerium oxide slurry can be added to the chemical additive solution. The treatment can be performed either at room temperature or at elevated temperature with subsequent pH adjustment. The collected cerium oxide particles from the centrifugation are mixed with deioized water to form a new cerium oxide slurry.

### Working Example

Lower concentration oxalic acid (0.01M )was used to treat 12 wt% cerium oxide slurry first. The mixture of lower concentration oxalic acid with 12 wt% cerium oxide slurry was stirred and heated for 3 to 4 hours under N₂ protection. Upon the completion of the heating treatment process, the mixed solution of oxalic acid with cerium oxide particles was centrifuged and the supernatant solution was decanted off.

The deionized water was then added to the cerium oxide particles collected from the centrifuge process as the precipitate. The resulting cerium oxide slurry was adjusted to a basic pH condition using a low concentration of KOH.

The trace metal ion concentrations in the treated cerium oxide slurry were analysed by ICP-Mass Spectroscopy analysis through full digestion method.

**Table 7. Effects of Chemical Additive Treatment at Heating Condition on Al, Mg, and Zr Ion Concentrations in Cerium Oxide Particle Slurry**

| Sample | AI ion (ppb) | Mg ion (ppb) | Zr ion(ppb) |
|---|---|---|---|
| Untreated cerium oxide slurry | 11,000 | 120 | 2700,000 |
| Treated with oxalic acid at 70°C | 5,660 | 157 | 57,000 |

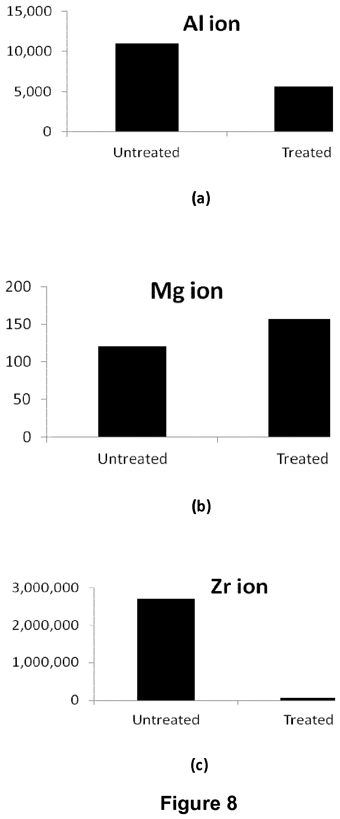

As the results shown in Table 7 and Figure 8, the ion exchange treatment processes reduced trace metal ion concentrations, especially Aluminum ion concentrations.

All three different ion-exchange resin treatments have shown reduced trace aluminum ion concentrations to different degrees while comparing to the aluminum ion concentrations detected for the original cerium oxide slurry without using ion exchange resin treatments.

The analytic results of several trace metal ion concentrations in the treated cerium oxide slurry along with those trace metal ion concentrations in an untreated cerium oxide slurry are listed in Table 7 and Figure 8(a)-(c).

As shown in Table 7, the AI and Zr metal ion concentrations were reduced by a relatively large percentage after the treatment. Mg ion concentration was slightly increased after the treatment. These results indicated that the treatment was an effective way to remove some trace metal ions, such as AI and Zr, from cerium oxide slurry.

Further shown in Table 7, using the chemical additives to treat the cerium oxide particles in solution at different temperatures was an efficient approach to reduce the AI and Zr contents in cerium oxide particles. Such effective AI and Zr content reduction is mainly due to these chemical additives being able to react with AI or Zr contained on cerium particle surfaces to convert them to the soluble AI or Zr chemical additive complexes, after which the cerium oxide particles can be separated from supernatant and re-dispersed to make STI slurry formulations with reduced AI and Zr contents.

When the concentration of oxalic acid was changed from 0.01 M to 0.1 M, there was no impact observed on AI content (ppb) which indicated that 0.01 M of oxalic acid concentration was adequate for the efficient removal of some AI and Zr contents from cerium oxide particles.

The cerium oxide slurry after chemical additive treatment can be used to prepare STI polishing compositions.

The different treatments, methods or embodiments for reducing trace metal and smaller sized and fine cerium oxide particles described above, can be combined in any orders. For example, the cerium oxide slurry being treated by any one of the method described above, can be further treated by any other, or any combinations of other methods. For example, the cerium oxide slurry being treated by suitable chemical additives, can be further treated by any one, or combinations of, chemical chelator treatment; and ion exchange resin treatment described above.

Upon the reduction of trace metal contaminants in the cerium oxide slurry, the treated cerium oxide slurry is used to make STI polishing compositions. Defects, such as metal ions penetrating into silicon oxide films or forming nano-sized residues on wafer surfaces from a STI CMP process can thus be reduced.

## Claims

1. A method of reducing trace metal contaminants and/or reducing cerium oxide particles having a particle size of less than 10 nm in a cerium oxide slurry, the method
comprising one or more of the following steps (I) to (III):
(I) (a) adding an ion exchange resin to the cerium oxide slurry; and (b) removing the ion exchange resin from the cerium oxide slurry through filtration to obtain treated cerium oxide slurry; wherein the ion exchange resin is a cationic ion exchange resin selected from a cationic ion exchange resin having protons or potassium ions or an anionic ion exchange resin having a hydroxyl group;
(II)(a) adding a chemical additive to the cerium oxide slurry to form a mixture, wherein the chemical additive reacts with trace metal ions in the trace metal contaminants to form water soluble chemical additive-metal ion complexes in the mixture; (b) centrifuging the mixture; (c) collecting cerium oxide particles from the precipitate of the centrifugation; and (d) mixing deionized water with the collected cerium oxide particles to obtain a treated cerium oxide slurry; and
(III) adding a chemical chelator to the cerium oxide slurry to obtain treated cerium oxide slurry;
wherein
the chemical additive is selected from the group consisting of (a) organic acids selected from the group consisting of
oxalic acid, citric acid, malic acid, tartaric acid, maleic acid, itaconic acid, gluconic acid, lactic acid, ETDA, and combinations thereof; (b) amino acids selected from the group consisting of glycine, alanine, serine, proline, and combinations thereof; (c) organic compounds containing at least one carboxylic acid group; (d) amino acid derivatives containing at least one amine acid moiety or iminodiacetic acid; (e) organic amine
compounds selected from the group consisting of ethylene diamine, propylene diamine, ethylenimine, organic compound containing primary or secondary amino groups, and combinations thereof; (f) organic sulfuric acids containing at least one sulfuric acid group; (g) organic phosphoric acids containing at least one phosphoric acid group; (h) pyridine and its derivatives selected from the group consisting of pyridine, 2-methyl
pyridine, substituted pyridine at position 2, 3, 4, 5 or 6 respectively, and combinations thereof; (i) bipyridine and its derivatives selected from the group consisting of 2,2'- bipyrine, 4,4'-dimethyl bipyridine, 4,4'-bipyridine, and all other substituted 2,2'-bipyrine or 4,4'-bipyridine derivatives, and combinations thereof; U)terpyridine and its derivatives; (k) quinoline and its derivatives; (I) hydroxyl quinoline and its derivatives; (m) ammonium
hydroxide; and combinations thereof; and
the chemical chelator is hydroxyl quinoline or its derivative having a chemical structure selected from the group consisting of: 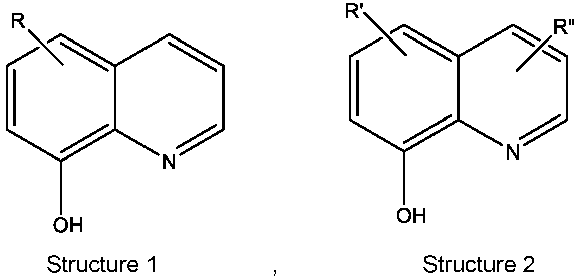 and combinations thereof;
wherein R is selected from the group consisting of hydrogen, alkyl, alkoxy, organic group with one or more hydroxyl groups, substituted organic sulfonic acid, substituted organic sulfonic acid salt, substituted organic carboxylic acid, substituted organic carboxylic acid
salt, organic carboxylic ester, organic amine groups, and combinations thereof; and
R' and R" can be the same or different, and are independently selected from the group consisting of hydrogen, alkyl, alkoxy, organic group with one or more hydroxyl groups, substituted organic sulfonic acid, substituted organic sulfonic acid salt, substituted organic carboxylic acid, substituted organic carboxylic acid salt, organic carboxylic ester, organic amine, and combinations thereof;
wherein the chemical chelator reacts with trace metal ions in trace metal contaminants to form metal ion-chelator complexes.

2. The method of Claim 1, wherein the method comprises step (I).

3. The method of Claim 2, wherein the ion exchange resin is a cationic ion exchange resin having potassium ions; the method in step (I) further comprising
(c) adding an anionic ion exchange resin having a hydroxyl group to the treated cerium oxide slurry after step (b); and
(d) removing the anionic ion exchange resin from the cerium oxide slurry in (c) through filtration; and
wherein the method preferably comprises repeating steps (a) to (d) at least twice.

4. The method of any one of Claims 1 to 3, wherein the method comprises the step of of running deionized water through the cerium oxide slurry using at least one ultra filtration membrane to obtain a treated cerium oxide slurry as retentate.

5. The method of Claim 4, wherein the method further comprises sonication.

6. The method of any one of Claims 1 to 5, wherein the method comprises the steps of
(a) centrifuging the cerium oxide slurry; (b) collecting cerium oxide particles from the precipitate of centrifugation; (c) mixing deionized water with the collected cerium oxide
at least twice; so as to obtain a treated cerium oxide slurry comprising cerium oxide particles from the precipitate of the last centrifugation.

7. The method of any of Claims 1 to 6, wherein the method comprises step (II).

8. The method of Claim 1, wherein the chemical additive in step (II) is oxalic acid having concentration ranging from 0.01 M to 0.1M.

9. The method of any one of Claims 1 to 8, wherein the method comprises step (III).

10. The method of Claim 9, wherein the chemical chelator is selected from the group consisting of 8-hydroxyl quinoline, 8-hydroxyl quinoline-5-sulfonic acid, and combinations thereof.

11. A method of forming a chemical mechanical polishing (CMP) composition for Shallow Trench Isolation (STI) comprising:
(a) reducing trace metal contaminants and/or reducing cerium oxide particles having a particle size of less than 10 nm in a cerium oxide slurry in accordance with any one of Claims 1 to 12 to form a treated cerium oxide slurry;
(b) adding a polymeric electrolyte to the treated cerium oxide slurry; and
(c) adding a biocide to the treated cerium oxide slurry.

12. The method of Claim 11, wherein the polymeric electrolyte is selected from the group consisting of an ammonium salt of polyacrylic acid, an ammonium salt of polyvinyl sulfonic acid, an ammonium salt of poly(4-styrene sulfonic acid), and combinations thereof.

13. A method of Chemical Mechanical Polishing (CMP) a substrate having atleast one surface comprising silicon dioxide in a Shallow Trench Isolation (STI) process, comprising polishing the substrate using a Chemical Mechanical Polishing (CMP) composition selected from:
(a) a composition comprising a treated cerium oxide slurry obtained by the method of any one of Claims 1 to 10; and
(b) a composition obtained by the method of any one of Claims 11 to 12.

## Patentansprüche

1. Verfahren zum Verringern von Spurenmetallverunreinigungen und/oder zum Verringern von Ceroxidpartikeln mit einer Partikelgröße von weniger als 10 nm in einer Ceroxidaufschlämmung, wobei das Verfahren einen oder mehrere der folgenden Schritte (I) bis (III) umfasst:
(I) (a) Zugeben eines lonenaustauscherharzes zu der Ceroxidaufschlämmung; und (b) Entfernen des lonenaustauscherharzes aus der Ceroxidaufschlämmung durch Filtration, um eine behandelte Ceroxidaufschlämmung zu erhalten; wobei das lonenaustauscherharz ein kationisches lonenaustauscherharz ist, ausgewählt aus einem kationischen lonenaustauscherharz mit Protonen oder Kaliumionen und einem anionischen lonenaustauscherharz mit einer Hydroxylgruppe;
(II) (a) Zugeben eines chemischen Additivs zu der Ceroxidaufschlämmung, um eine Mischung auszubilden, wobei das chemische Additiv mit Spurenmetallionen in den Spurenmetallverunreinigungen reagiert, um wasserlösliche chemische Additiv-Metallionen-Komplexe in der Mischung auszubilden; (b) Zentrifugieren der Mischung; (c) Sammeln von Ceroxidpartikeln aus dem Niederschlag der Zentrifugation; und (d) Mischen von entionisiertem Wasser mit den gesammelten Ceroxidpartikeln, um eine behandelte Ceroxidaufschlämmung zu erhalten; und
(III) Zugeben eines chemischen Chelatbildners zu der Ceroxidaufschlämmung, um eine behandelte Ceroxidaufschlämmung zu erhalten;
wobei das chemische Additiv aus der Gruppe ausgewählt ist, die aus (a) organischen Säuren, aus der Gruppe ausgewählt, die aus Oxalsäure, Zitronensäure, Äpfelsäure, Weinsäure, Maleinsäure, Itaconsäure, Gluconsäure, Milchsäure, ETDA sowie Kombinationen daraus besteht; (b) Aminosäuren, aus der Gruppe ausgewählt, die aus Glycin, Alanin, Serin, Prolin sowie Kombinationen daraus besteht; (c) organischen Verbindungen, die mindestens eine Carbonsäuregruppe enthalten; (d) Aminosäurederivaten, die mindestens eine Aminosäureeinheit oder Iminodiessigsäure enthalten; (e) organischen Aminverbindungen, aus der Gruppe ausgewählt, die aus Ethylendiamin, Propylendiamin, Ethylenimin, organischen Verbindungen, die primäre oder sekundäre Aminogruppen enthalten, sowie Kombinationen daraus besteht; (f) organischen Schwefelsäuren, die mindestens eine Schwefelsäuregruppe enthalten; (g) organischen Phosphorsäuren, die mindestens eine Phosphorsäuregruppe enthalten; (h) Pyridin und seinen Derivaten, aus der Gruppe ausgewählt, die aus Pyridin, 2-Methylpyridin, an Position 2, 3, 4, 5 bzw. 6 substituiertem Pyridin sowie Kombinationen daraus besteht; (i) Bipyridin und seinen Derivaten, aus der Gruppe ausgewählt, die aus 2,2'-Bipyrin, 4,4'-Dimethylbipyridin, 4,4'-Bipyridin und allen anderen substituierten 2,2'-Bipyrin- oder 4,4'-Bipyridinderivaten sowie Kombinationen daraus besteht; (j) Terpyridin und seinen Derivaten; (k) Chinolin und seinen Derivaten; (I) Hydroxychinolin und seinen Derivaten; (m) Ammoniumhydroxid; sowie Kombinationen daraus; besteht und
der chemische Chelator Hydroxychinolin oder ein Derivat davon ist, mit einer chemischen Struktur, ausgewählt aus der Gruppe, die aus: 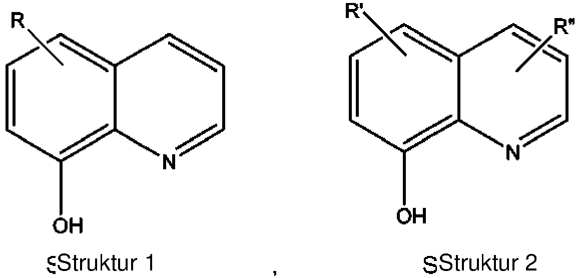 sowie Kombinationen daraus besteht;
wobei R ausgewählt ist aus der Gruppe, die aus Wasserstoff, Alkyl, Alkoxy, organischer Gruppe mit einer oder mehreren Hydroxylgruppen, substituierter organischer Sulfonsäure, substituiertem organischem Sulfonsäuresalz, substituierter organischer Carbonsäure, substituiertem organischem Carbonsäuresalz, organischem Carbonsäureester, organischen Amingruppen sowie Kombinationen daraus besteht; und
R' und R" gleich oder verschieden sein können und unabhängig ausgewählt sind aus der Gruppe, die aus Wasserstoff, Alkyl, Alkoxy, organischer Gruppe mit einer oder mehreren Hydroxylgruppen, substituierter organischer Sulfonsäure, substituiertem organischem Sulfonsäuresalz, substituierter organischer Carbonsäure, substituiertem organischem Carbonsäuresalz, organischem Carbonsäureester, organischem Amin sowie Kombinationen daraus besteht;
wobei der chemische Chelatbildner mit Spurenmetallionen in Spurenmetallverunreinigungen reagiert, um Metallion-Chelatbildner-Komplexe auszubilden.

2. Verfahren nach Anspruch 1, wobei das Verfahren Schritt (I) umfasst.

3. Verfahren nach Anspruch 2, wobei das lonenaustauscherharz ein kationisches lonenaustauscherharz mit Kaliumionen ist; wobei das Verfahren in Schritt (I) ferner Folgendes umfasst:
(c) Zugeben eines anionischen lonenaustauscherharzes mit einer Hydroxylgruppe zu der behandelten Ceroxidaufschlämmung nach Schritt (b); und
(d) Entfernen des anionischen lonenaustauscherharzes aus der Ceroxidaufschlämmung in (c) durch Filtration; und
wobei das Verfahren vorzugsweise das mindestens zweimalige Wiederholen der Schritte (a) bis (d) umfasst.

4. Verfahren nach einem der Ansprüche 1 bis 3, wobei das Verfahren den Schritt des Durchleitens von entionisiertem Wasser durch die Ceroxidaufschlämmung unter Verwendung von mindestens einer Ultrafiltrationsmembran umfasst, um eine behandelte Ceroxidaufschlämmung als Retentat zu erhalten.

5. Verfahren nach Anspruch 4, wobei das Verfahren ferner Beschallung umfasst.

6. Verfahren nach einem der Ansprüche 1 bis 5, wobei das Verfahren die folgenden Schritte umfasst:
(a) Zentrifugieren der Ceroxidaufschlämmung; (b) Sammeln von Ceroxidpartikeln aus dem Zentrifugationsniederschlag; (c) mindestens zweimaliges Mischen von entionisiertem Wasser mit dem gesammelten Ceroxid, um aus dem Niederschlag der letzten Zentrifugation eine behandelte Ceroxidaufschlämmung mit Ceroxidpartikeln zu erhalten.

7. Verfahren nach einem der Ansprüche 1 bis 6, wobei das Verfahren Schritt (II) umfasst.

8. Verfahren nach Anspruch 1, wobei das chemische Additiv in Schritt (II) Oxalsäure mit einer Konzentration im Bereich von 0,01 M bis 0,1 M ist.

9. Verfahren nach einem der Ansprüche 1 bis 8, wobei das Verfahren Schritt (III) umfasst.

10. Verfahren nach Anspruch 9, wobei der chemische Chelatbildner ausgewählt ist aus der Gruppe bestehend aus 8-Hydroxychinolin, 8-Hydroxychinolin-5-sulfonsäure sowie Kombinationen daraus.

11. Verfahren zum Ausbilden einer chemisch-mechanischen Polierzusammensetzung (CMP) zur Grabenisolation (*Shallow Trench Isolation* - STI), umfassend:
(a) Verringern von Spurenmetallverunreinigungen und/oder Verringern von Ceroxidpartikeln mit einer Partikelgröße von weniger als 10 nm in einer Ceroxidaufschlämmung nach einem der Ansprüche 1 bis 12, um eine behandelte Ceroxidaufschlämmung auszubilden;
(b) Zugeben eines polymeren Elektrolyten zu der behandelten Ceroxidaufschlämmung; und
(c) Zugeben eines Biozids zu der behandelten Ceroxidaufschlämmung.

12. Verfahren nach Anspruch 11, wobei der polymere Elektrolyt ausgewählt ist aus der Gruppe bestehend aus einem Ammoniumsalz von Polyacrylsäure, einem Ammoniumsalz von Polyvinylsulfonsäure, einem Ammoniumsalz von Poly(4-styrolsulfonsäure) sowie Kombinationen daraus.

13. Verfahren zum chemisch-mechanischen Polieren (CMP) eines Substrats mit mindestens einer Oberfläche, umfassend Siliziumdioxid in einem Grabenisolationsprozess (STI), umfassend das Polieren des Substrats unter Verwendung einer chemisch-mechanischen Polierzusammensetzung (CMP), ausgewählt aus:
(a) einer Zusammensetzung, umfassend eine behandelte Ceroxidaufschlämmung, erhalten durch das Verfahren nach einem der Ansprüche 1 bis 10; und
(b) einer Zusammensetzung, erhalten durch das Verfahren nach einem der Ansprüche 11 bis 12.

## Revendications

1. Procédé de réduction de contaminants métaux traces et/ou de réduction de particules d'oxyde de cérium ayant une dimension de particule inférieure à 10 nm dans une suspension d'oxyde de cérium, le procédé
comprenant une ou plusieurs des étapes (I) à (III) suivantes :
(I) (a) l'ajout d'une résine échangeuse d'ions à la suspension d'oxyde de cérium ; et (b) l'élimination de la résine échangeuse d'ions de la suspension d'oxyde de cérium par filtration pour obtenir une suspension d'oxyde de cérium traitée ; la résine échangeuse d'ions étant une résine échangeuse d'ions cationique choisie parmi une résine échangeuse d'ions cationique ayant des protons ou des ions potassium ou une résine échangeuse d'ions anionique ayant un groupe hydroxyle ;
(II) (a) l'ajout d'un additif chimique à la suspension d'oxyde de cérium pour former un mélange, l'additif chimique réagissant avec les ions de métaux traces dans les contaminants métaux traces pour former des complexes additif chimique-ion métallique hydrosolubles dans le mélange ; (b) la centrifugation du mélange ; (c) la collecte de particules d'oxyde de cérium du précipité de la centrifugation ; et (d) le mélange de l'eau désionisée avec les particules d'oxyde de cérium collectées pour obtenir une suspension d'oxyde de cérium traitée ; et
(III) l'ajout d'un chélateur chimique à la suspension d'oxyde de cérium pour obtenir une suspension d'oxyde de cérium traitée ;
l'additif chimique étant choisi parmi le groupe constitué par (a) les acides organiques choisis parmi le groupe constitué par
l'acide oxalique, l'acide citrique, l'acide malique, l'acide tartrique, l'acide maléique, l'acide itaconique, l'acide gluconique, l'acide lactique, l'ETDA et leurs combinaisons ; (b) les acides aminés choisis parmi le groupe constitué par la glycine, l'alanine, la sérine, la proline et leurs combinaisons ; (c) les composés organiques contenant au moins un groupe acide carboxylique ; (d) les dérivés d'acides aminés contenant au moins un fragment acide aminé ou acide iminodiacétique ;
(e) les composés d'amine organique
choisis parmi le groupe constitué par l'éthylène diamine, le propylène diamine, l'éthylènimine, un composé organique contenant des groupes amino primaires ou secondaires, et leurs combinaisons ; (f) les acides sulfuriques organiques contenant au moins un groupe acide sulfurique ; (g) les acides phosphoriques organiques contenant au moins un groupe acide phosphorique ; (h) la pyridine et ses dérivés choisis parmi le groupe constitué par la pyridine, le 2-méthyl pyridine, la pyridine substituée en position 2, 3, 4, 5 ou 6 respectivement, et leurs combinaisons ; (i) la bipyridine et ses dérivés choisis parmi le groupe constitué par la 2,2'-bipyrine, la 4,4'-diméthyl bipyridine, la 4,4'-bipyridine et tous les autres dérivés de 2,2'-bipyrine ou 4,4'-bipyridine substituées, et leurs combinaisons ;
(j) la terpyridine et ses dérivés ; (k) la quinoléine et ses dérivés ; (I) l'hydroxyle quinoléine et ses dérivés ; (m) l'hydroxyde d'ammonium ; et leurs combinaisons ; et
le chélateur chimique est l'hydroxyle quinoléine ou son dérivé ayant une structure chimique choisie parmi le groupe constitué par : 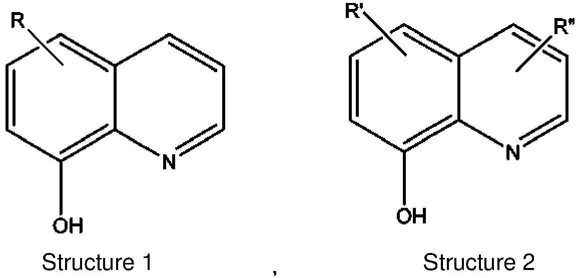 et leurs combinaisons ;
R étant choisi parmi le groupe constitué par l'hydrogène, l'alkyle, l'alcoxy, le groupe organique avec un ou plusieurs groupes hydroxyle, l'acide sulfonique organique substitué, le sel d'acide sulfonique organique substitué, l'acide carboxylique organique substitué, le sel d'acide carboxylique organique substitué, l'ester carboxylique organique, les groupes amine organique et leurs combinaisons ; et
R' et R" pouvant être identiques ou différents, et étant indépendamment choisis parmi le groupe constitué par l'hydrogène, l'alkyle, l'alcoxy, le groupe organique avec un ou plusieurs groupes hydroxyle, l'acide sulfonique organique substitué, le sel d'acide sulfonique organique substitué, l'acide carboxylique organique substitué, le sel d'acide carboxylique organique substitué, l'ester carboxylique organique, l'amine organique et leurs combinaisons ;
le chélateur chimique réagissant avec les ions de métaux traces dans les contaminants métaux traces pour former des complexes ions métalliques-chélateurs.

2. Procédé selon la revendication 1, dans lequel le procédé comprend l'étape (I).

3. Procédé selon la revendication 2, dans lequel la résine échangeuse d'ions est une résine échangeuse d'ions cationique ayant des ions potassium ; le procédé de l'étape (I) comprenant en outre
(c) l'ajout d'une résine échangeuse d'ions anionique ayant un groupe hydroxyle à la suspension d'oxyde de cérium traitée après l'étape (b) ; et
(d) l'élimination de la résine échangeuse d'ions anionique de la suspension d'oxyde de cérium en (c) par filtration ; et
le procédé comprenant de préférence la répétition des étapes (a) à (d) au moins deux fois.

4. Procédé selon l'une quelconque des revendications 1 à 3, dans lequel le procédé comprend l'étape consistant à faire passer de l'eau désionisée à travers la suspension d'oxyde de cérium à l'aide d'au moins une membrane d'ultrafiltration pour obtenir une suspension d'oxyde de cérium traitée comme rétentat.

5. Procédé selon la revendication 4, dans lequel le procédé comprend en outre la sonication.

6. Procédé selon l'une quelconque des revendications 1 à 5, dans lequel le procédé comprend les étapes de
(a) centrifugation de la suspension d'oxyde de cérium ; (b) collecte de particules d'oxyde de cérium du précipité de centrifugation ; (c) mélange de l'eau désionisée avec l'oxyde de cérium collecté
au moins deux fois ; de manière à obtenir une suspension d'oxyde de cérium traitée comprenant des particules d'oxyde de cérium à partir du précipité de la dernière centrifugation.

7. Procédé selon l'une quelconque des revendications 1 à 6, dans lequel le procédé comprend l'étape (II).

8. Procédé selon la revendication 1, dans lequel l'additif chimique dans l'étape (II) est l'acide oxalique ayant une concentration allant de 0,01 M à 0,1 M.

9. Procédé selon l'une quelconque des revendications 1 à 8, dans lequel le procédé comprend l'étape (III).

10. Procédé selon la revendication 9, dans lequel le chélateur chimique est choisi parmi le groupe constitué par la 8-hydroxylquinoléine, l'acide 8-hydroxylquinoléine-5-sulfonique, et leurs combinaisons.

11. Procédé de formation d'une composition de polissage mécano-chimique (CMP) pour l'isolation par tranchées peu profondes (STI) comprenant :
(a) la réduction de contaminants métaux traces et/ou la réduction de particules d'oxyde de cérium ayant une dimension de particule inférieure à 10 nm dans une suspension d'oxyde de cérium avec l'une quelconque des revendications 1 à 12 pour former une suspension d'oxyde de cérium traitée ;
(b) l'ajout d'un électrolyte polymère à la suspension d'oxyde de cérium traitée ; et
(c) l'ajout d'un biocide à la suspension d'oxyde de cérium traitée.

12. Procédé selon la revendication 11, dans lequel l'électrolyte polymère est choisi parmi le groupe constitué d'un sel d'ammonium d'acide polyacrylique, d'un sel d'ammonium d'acide polyvinylsulfonique, d'un sel d'ammonium de poly(acide-4-styrène sulfonique), et leurs combinaisons.

13. Procédé de polissage mécano-chimique (CMP) d'un substrat ayant au moins une surface comprenant du dioxyde de silicium dans un processus d'isolation par tranchées peu profondes (STI), comprenant le polissage du substrat à l'aide d'une composition de polissage mécano-chimique (CMP) choisie parmi :
(a) une composition comprenant une suspension d'oxyde de cérium traitée obtenue par le procédé de l'une quelconque des revendications 1 à 10 ; et
(b) une composition obtenue par le procédé de l'une quelconque des revendications 11 à 12.
